# EUROPÄISCHE PATENTSCHRIFT

(11) **EP 0 612 825 B1**
(45) Veröffentlichungstag und Bekanntmachung des Hinweises auf die Patenterteilung: **10.10.2001**
(21) Anmeldenummer: 94102263.4
(22) Anmeldetag: 15.02.1994
(51) Int. Cl.: C09K 5/04, H01L 23/473

(54) **Verwendung von weitgehend fluorierten Verbindungen als Wärmeträger**
Use of highly fluorinated compositions as a heat-carrier
Utilisation de compositions largement fluorées comme agent caloporteur

(30) Priorität: 20.02.1993 DE 4305239
(43) Veröffentlichungstag der Anmeldung: 31.08.1994
(73) Patentinhaber: SOLVAY (Société Anonyme), 1050 Bruxelles (BE)
(72) Erfinder: Becker, Wilfried, Dr., D-84524 Neuötting (DE)
(74) Vertreter: Jacques, Philippe

(56) Entgegenhaltungen:
- US-A- 3 362 180
- US-A- 4 730 460
- DATABASE WPI Week 8047, Derwent Publications Ltd., London, GB; AN 80-83722C & JP-A-55 131 096 (DAIKIN)
- IBM TECHNICAL DISCLOSURE BULLETIN Bd. 21, Nr. 8 , Januar 1979 , US Seiten 3378 - 3380 AHEARN ET AL. 'SILICON HEAT SINK METHOD TO CONTROL INTEGRETATED CIRCUIT CHIP OPERATING TEMPERATURES.'
- PATENT ABSTRACTS OF JAPAN vol. 8, no. 25 (E-225)2. Februar 1984 & JP-A-58 186 955 (TOKYO SHIBAURA DENKI KK)

## Beschreibung

Die in Bauelementen der Leistungselektronik auftretende Wärme muß durch Wärmeträger abgeführt werden, zum Beispiel beim Einsatz von Leistungshalbleitern für die Hochspannungs-Gleichstrom-Übertragung oder für Bahnantriebe. Hierbei kann die Kühlung durch einphasige Konvektion, das heißt ohne Veränderung des Aggregatszustandes des Kühlmittels, oder durch zweiphasige Kühlung nach dem Prinzip der Verdampfungskühlung - auch "Siedekühlung" genannt - erfolgen, wobei die zweiphasige Kühlung wesentlich leistungsfähiger ist. Hierbei können die wärmeerzeugenden Bauelemente direkt in der siedenden Flüssigkeit liegen oder die Flüssigkeit siedet in hohlen Kühldosen (Badbeziehungsweise Dosensiedekühlung).

Als Wärmeträger und insbesondere als Siedekühlflüssigkeiten haben sich flüssige Halogenkohlenwasserstoffe, insbesondere Fluorchlorkohlenwasserstoffe, bewährt. Insbesondere das 1,1,2-Trichlor-1,2,2-trifluorethan (F113) war wegen seiner guten thermischen Stabilität, Unbrennbarkeit, geringen Viskosität, relativ hohen Verdampfungswärme und der günstigen elektrophysikalischen und physiologischen Eigenschaften als kostengünstige Siedekühlflüssigkeit vielfach eingesetzt. Fluorchlorkohlenwasserstoffe gelten jedoch als schädlich für das Ozon in der Stratosphäre und müssen deshalb durch andere Stoffe ersetzt werden.

Es wurde nun gefunden, daß nicht brennbare, weitgehend fluorierte Verbindungen aus der Reihe der Alkane mit mindestens 3 Kohlenstoffatomen und/oder Dialkylether, wie in Anspruch 1 beschrieben, als Wärmeträger in einer Methode zur Abführung von Wärme von einem elektronischen Bauelement durch direkte Berührung geeignet sind. Der Begriff "weitgehend fluoriert" ist hierbei im Zusammenhang mit "nicht brennbar" zu verstehen, das heißt, daß bis zum Siedepunkt nach DIN 51 755 kein Flammpunkt festgestellt werden kann.

Die Auswahl der fluorierten Alkane beziehungsweise Dialkylether, der Formeln (1) und (2) richtet sich nach deren Siedepunkt. Als Ersatz für F113 (Kp 47,6 °C) kommt somit beispielsweise 1,4-Dihydroperfluorbutan mit einem Siedepunkt von 44 °C, aber auch höher siedende Flüssigkeiten wie 1-Hydro-n-perfluorhexan mit einem Siedepunkt von 70 °C in Betracht.

Geeignet sind Fluoralkane der Formel (1)

CₙF₂ₙ₊₂₋ₐHₐ (1)

in der n 3 bis 6, vorzugsweise 4 bis 6, und
a 1 bis (n + 1) bedeuten,
sowie fluorierte Ether der Formel (2)

CₘF_{2m+1-b}H_{b}-O-CₚF_{2p+1-c}H_{c} (2)

in der, unabhängig voneinander, m und p 1 bis 4, (m + p) aber höchstens 5 ist, und (b + c) 1 bis (m + p + 1) ist.

Allgemein gilt also, daß die Anzahl der Wasserstoffatome höchstens gleich der Anzahl der Fluoratome ist, da die Verbindungen mit höherem Wasserstoffgehalt im allgemeinen brennbar sind.

Die Erfindung ist jedoch nicht auf reine Substanzen beschränkt, sondern umfaßt vielmehr auch Gemische geeigneter Flüssigkeiten, die häufig schon aus Gründen der leichten Zugänglichkeit und damit des Preises Vorteile bieten. Die Erfindung bezieht sich jedoch auch auf Mischungen geeigneter Flüssigkeiten, die zum Zwecke der Siedepunktserniedrigung kombiniert werden.

Es wurde weiterhin gefunden, daß für geeignete Mischungen auch brennbare Flüssigkeiten dienen können, beispielsweise niedrig fluorierte Ether, die also weniger Fluor- als Wasserstoffatome enthalten, wenn nur das einzusetzende Gemisch dem obengenannten Kriterium der Nichtbrennbarkeit genügt. Bevorzugt sind Mischungen aus weitgehend fluorierten Alkanen oder weitgehend fluorierten Dialkylethern mit flüssigen, niederen Dialkylethern, Kohlenwasserstoffen und niederen Alkanolen, insbesondere Methanol, Ethanol oder Isopropanol, wobei azeotrope Gemische oder Gemische mit unter-azeotropen Mengen an zugesetzter Flüssigkeit bevorzugt sind.

Ein besonderer Vorteil von niederen Alkanolen als Mischungskomponenten ist darin zu sehen, daß diese mit hochfluorierten verzweigten Olefinen vom Typ des Octafluorisobutens reagieren (Houben-Weyl, Methoden der organischen Chemie, 4. Auflage, Band V/3, Seite 280), wobei die meist toxischen verzweigtkettigen Olefine in nicht toxische Ether überführt werden. Die genannten Olefine können einerseits in technischen Produkten als Verunreinigung enthalten sein, andererseits aber auch beim Einsatz infolge von Funkendurchschlägen oder anderen extremen Belastungen gebildet werden. Diese bevorzugte Ausführungsform der Erfindung bietet also eine zusätzliche Sicherheit bei der Anwendung.

Die Erfindung wird im folgenden anhand von Beispielen für den Ersatz von F113 näher erläutert.

Selbstverständlich erstreckt sich aber der Bereich der Erfindung auch auf den Ersatz von anderen Halogenkohlenwasserstoffen als Wärmeträger in einer Methode zur Abführung von Wärme von einem elektronischen Baulelement durch direkte Berührung.

Bei den in der folgenden Tabelle zusammengefaßten Beispielen bedeuten Prozentangaben Gewichtsprozente. Die Siedepunkte (Kp) sind in °C angegebenen.

**Tabelle**

| Beispiel | Substanz(en) | Kp |
|---|---|---|
| 1 | H-(CF₂)₄-H (A) | 44 |
| 2 | H-(CF₂)₆-F (B) | 70 |
| 3 | F₃C-CH₂-O-(CF₂)₂-H (C) | 56,7 |
| 4 | (F₃C)₂CF-(CFH)₂-CF₃ (D) | 68 |
| 5 | (F₃C)₂CF-CH₂-CFH-CF₃ (E) | 65 |
| 6 | 17 bis 7 % B + 83 bis 93 % C | 56 bis 57*) |
| 7 | 21 bis 11 % D + 79 bis 89 % C | 56 bis 57*) |
| 8 | 96,4 % A + 3,6 % CH₃OH | 41,6*) |
| 9 | 92,6 % B + 7,4 % CH₃OH | 53,5*) |
| 10 | 90,7 % B + 9,3 % (CH₃)₂CHOH | 63,4*) |
| 11 | 93,7 % C + 6,3 % C₂H₅OH | 53,1*) |
| 12 | 90 % E + 10 % CH₃OH | 49*) |

| | | |
|---|---|---|
| *) azeotrope Mischung | | |

## Patentansprüche

1. Methode zur Abführung von Wärme von einem elektronischen Bauelement, bei der Wärme von dem elektronischen Bauelement durch direkte Berührung auf einen flüssigen Wärmeträger übertragen wird, wobei der Wärmeträger ein nicht brennbares fluoriertes Alkan der Formel (1)
CₙF₂ₙ₊₂₋ₐHₐ (1)
in der n 3 bis 6 und a 1 bis (n+1) bedeuten
oder einen nicht brennbaren fluorierten Ether der Formel (2)
CₘF_{2m+2-b}H_{b}-O- CₚF_{2p+2-c}H_{c} (2)
in der, unabhängig voneinander, m und p 1 bis 4 bedeuten, (m+p) aber höchstens 5 ist und b+c 1 bis (m+p+1) ist,
oder eine Mischung eines der genannten fluorierten Alkane und eines der genannten fluorierten Ether enthält.

2. Methode nach Anspruch 1, wobei der Wärmeträger (a) eines der in Anspruch 1 genannten fluorierten Alkane oder einen der in Anspruch 1 genannten fluorierten Ether oder eine Mischung davon und, damit gemischt, (b) einen brennbaren niederen Kohlenwasserstoff, ein brennbares niederes Alkanol oder einen brennbaren niederen Dialkylether enthält, der (a) und (b) umfassende Wärmeträger aber nicht brennbar ist.

3. Methode nach Anspruch 2, wobei der Wärmeträger eine azeotrope Mischung ist.

4. Methode nach Anspruch 1, wobei der Siedepunkt des in Anspruch 1 genannten fluorierten Alkans und des in Anspruch 1 genannten fluorierten Ethers bei einer Temperatur von 44°C oder höher liegt.

5. Methode nach Anspruch 1 bis 4, wobei der Wärmeträger (a) eines der in Anspruch 1 genannten fluorierten Alkane enthält.

6. Methode nach Anspruch 1, wobei der Wärmeträger (a) aus einem der in Anspruch 1 genannten fluorierten Alkane besteht.

7. Methode nach Anspruch 1 bis 4, wobei der Wärmeträger (a) einen der in Anspruch 1 genannten fluorierten Ether enthält.

8. Methode nach Anspruch 1, wobei der Wärmeträger (a) aus einem der in Anspruch 1 genannten fluorierten Ether besteht.

## Claims

1. Method for removing heat from an electronic component, in which heat is transferred from the electronic component to a liquid heat transfer agent through direct contact, where the heat transfer agent comprises a non-flammable fluorinated alkane of the formula (1)
CₙF₂ₙ₊₂₋ₐHₐ (1)
in which n is 3 to 6 and a is 1 to (n+1)
or a non-flammable fluorinated ether of the formula (2)
CₘF_{2m+1-b}H_{b}-O-CₚF_{2p+1-c}H_{c} (2)
in which, independently of one another, m and p are 1 to 4, but (m+p) does not exceed 5, and b+c is 1 to (m+p+1),
or a mixture of one of said fluorinated alkanes and one of said fluorinated ethers.

2. Method according to Claim 1, where the heat transfer agent (a) comprises one of the fluorinated alkanes specified in Claim 1 or one of the fluorinated ethers specified in Claim 1 or a mixture thereof and, mixed therewith, (b) a flammable lower hydrocarbon, a flammable lower alkanol or a flammable lower dialkyl ether, but the heat transfer agent comprising (a) and (b) is non-flammable.

3. Method according to Claim 2, where the heat transfer agent is an azeotropic mixture.

4. Method according to Claim 1, where the boiling point of the fluorinated alkane specified in Claim 1 and of the fluorinated ether specified in Claim 1 is at a temperature of 44°C or above.

5. Method according to Claims 1 to 4, where the heat transfer agent (a) comprises one of the fluorinated alkanes specified in Claim 1.

6. Method according to Claim 1, where the heat transfer agent (a) consists of one of the fluorinated alkanes specified in Claim 1.

7. Method according to Claims 1 to 4, where the heat transfer agent (a) comprises one of the fluorinated ethers specified in Claim 1.

8. Method according to Claim 1, where the heat transfer agent (a) consists of one of the fluorinated ethers specified in Claim 1.

## Revendications

1. Procédé d'évacuation de la chaleur d'un module électronique, dans lequel la chaleur émise par le module électronique est transmise à un fluide caloporteur par contact direct, le fluide caloporteur contenant un alcane fluoré non combustible de formule (I)
CₙF₂ₙ₊₂ₐHₐ (1)
dans laquelle n représente 3 à 6 et a représente 1 à (n + 1),
ou un éther fluoré non combustible de formule (2)
CₘF_{2m+1-b}H_{b}-O-CₚF_{2p+1-c}H_{c} (2)
dans laquelle, indépendamment les uns des autres, m et p représentent 1 à 4, (m + p) valant au plus 5 et b + c valant 1 à (m + p + 1),
ou un mélange de l'un desdits alcanes fluorés et de l'un desdits éthers fluorés.

2. Procédé selon la revendication 1, dans lequel le caloporteur (a) contient l'un desdits alcanes fluorés selon la revendication 1 ou l'un desdits éthers fluorés selon la revendication 1 ou un mélange d'entre eux et, mélangé à eux, (b) un hydrocarbure inférieur combustible, un alcanol inférieur combustible ou un éther de dialkyle inférieur combustible, le caloporteur comprenant (a) et (b) n'étant cependant pas combustible.

3. Procédé selon la revendication 2, dans lequel le caloporteur est un mélange azéotrope.

4. Procédé selon la revendication 1, dans lequel le point d'ébullition dudit alcane fluoré selon la revendication 1 et dudit éther fluoré selon la revendication 1 se situe à une température de 44° C ou supérieure.

5. Procédé selon les revendications 1 à 4, dans lequel le caloporteur (a) contient l'un desdits alcanes fluorés selon la revendication 1.

6. Procédé selon la revendication 1, dans lequel le caloporteur (a) est constitué de l'un desdits alcanes fluorés selon la revendication 1.

7. Procédé selon les revendications 1 à 4, dans lequel le caloporteur (a) contient l'un desdits éthers fluorés selon la revendication 1.

8. Procédé selon la revendication 1, dans lequel le caloporteur (a) est constitué de l'un desdits éthers fluorés selon la revendication 1.
